# EUROPÄISCHE PATENTSCHRIFT

(11) **EP 0 602 109 B1**
(45) Veröffentlichungstag und Bekanntmachung des Hinweises auf die Patenterteilung: **23.07.1997**
(21) Anmeldenummer: 92918427.3
(22) Anmeldetag: 22.08.1992
(51) Int. Cl.: H03K 4/69

(54) **VERTIKALABLENKSCHALTUNG**
VERTICAL DEFLECTION CIRCUIT
CIRCUIT DE DEVIATION VERTICALE

(30) Priorität: 02.09.1991 DE 4129107
(43) Veröffentlichungstag der Anmeldung: 22.06.1994
(73) Patentinhaber: DEUTSCHE THOMSON-BRANDT GMBH, 78048 Villingen-Schwenningen (DE)
(72) Erfinder: ELGERT, Achim, D-7737 Bad Dürrheim (DE); HÖLZER, Thomas, D-7730 VS-Villingen (DE)
(86) Internationale Anmeldenummer: EP9201933
(87) Internationale Veröffentlichungsnummer: WO9305575

(56) Entgegenhaltungen:
- DE-A- 3 436 304
- IBM TECHNICAL DISCLOSURE BULLETIN. Bd. 31, Nr. 5, Oktober 1988, NEW YORK US Seiten 434 - 435 'LOW POWER DISSIPATION VERTICAL DEFLECTION CIRCUIT USING A COMMERCIAL MONOLITHIC INTEGRATED CIRCUIT'
- IBM TECHNICAL DISCLOSURE BULLETIN. Bd. 27, Nr. 3, August 1984, NEW YORK US Seiten 1797-1798 MORRISH A. J. 'active frame flyback circuit for crt'

## Beschreibung

Die Erfindung geht aus von einer Vertikalablenkschaltung gemäß dem Oberbegriff des Anspruchs 1.

Bei einer derartigen Vertikalablenkschaltung muß die Differenz zwischen der Rücklaufspannung und der angelegten Betriebsspannung maximal 50 Volt betragen. Bei Betrieb dieser Schaltung bei einer Vertikalablenkfrequenz von 100 Hz und einem entsprechend verkürztem Rücklauf und somit erhöhter Rücklaufspannung müßte daher die angelegte Betriebsspannung entsprechend erhöht werden. Die Betriebsspannung wäre dann größer, als sie an sich für den Hinlauf benötigt wird. Dadurch wird die Verlustleistung der gesamten Schaltung bei 100 Hz Betrieb beträchtlich erhöht.

IBM TECHNICAL DISCLOSURE BULLETIN, Nr. 5, 1988, Seiten 434-435, beschreibt eine Vertikalablenkschaltung unter Verwendung eines integrierten Schaltkreises mit einer extern zugeführten Betriebsspannung, die während des Hinlaufs einen ersten Wert und während des Rücklaufs einen zweiten, höheren, Wert annimmt. Dazu ist ein Schalttransistor vorgesehen, der über ein Differenzierglied, einen Spannungsteiler und einen weiteren Transistor vom Vertikal-Blanking-Impuls angesteuert wird. Dabei ist die Basis des weiteren Transistors an den Abgriff des Spannungsteilers angeschlossen, und liegt die Kollektor-Emitter-Strecke des Schalttransistors zwischen dem IC-Anschluß für die Zuführung der Betriebsspannung und der Spannungsquelle für die erhöhte Betriebsspannung.

Der Erfindung liegt die Aufgabe zugrunde, eine Vertikalablenkschaltung gemäß dem Oberbegriff des Anspruchs 1 so auszubilden, daß ein Betrieb bei einer erhöhten Vertikalablenkfrequenz von 100 Hz und schnellerem Vertikalrücklauf möglich ist, ohne daß die Verlustleistung während des Vertikalhinlaufs ansteigt.

Diese Aufgabe wird durch die im Anspruch 1 angegebene Erfindung gelöst. Vorteilhafte Weiterbildungen der Erfindung sind in den Unteransprüchen angegeben.

Innerhalb des IC erfolgt an sich bereits während des Rücklaufs eine Umschaltung auf eine an das IC angelegte Rücklaufbetriebsspannung, die größer ist als die während des Hinlaufs wirksame Betriebsspannung. Diese Umschaltung ist für Betrieb bei 50 Hz ausreichend, kann aber bei Betrieb mit 100 Hz und entsprechend verkürzter Rücklaufzeit nicht ohne Erhöhung der Verlustleistung arbeiten. Durch die Erfindung wird erreicht, daß das IC bei Betrieb mit einer Vertikalfrequenz von 100 Hz mit der gewünschten schnellen Stromänderung im Vertikalrücklauf arbeiten kann, ohne daß dabei die Verlustleistung im Vertikalhinlauf ansteigt. Die zweite Betriebsspannung ist unabhängig von der ersten Betriebsspannung beliebig wählbar, sofern die erforderlichen Betriebsbedingungen eingehalten werden. Diese Bedingungen bestehen im wesentlichen darin, daß die Betriebsspannung kleiner = 42 Volt ist und der Unterschied zwischen der Rücklaufspannung und der Betriebsspannung kleiner = 50 Volt beträgt.

Die Erfindung wird im folgenden anhand der Zeichnung an einem Beispiel erläutert. Darin zeigen
- Fig. 1: das IC für die Vertikalablenkschaltung mit der bekannten und der erfindungsgemäßen peripheren Schaltung und
- Fig. 2: Kurven zur Erläuterung der Wirkungsweise der Schaltung nach Fig. 1.

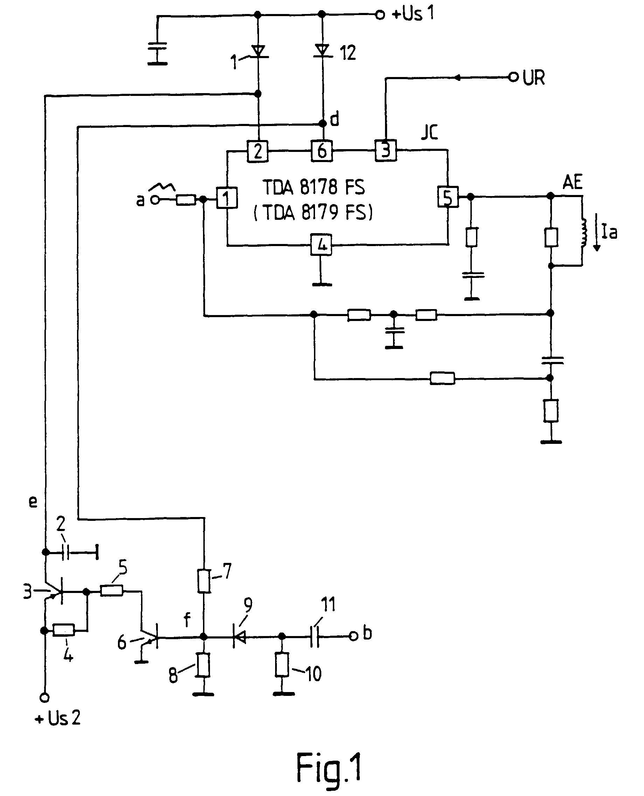

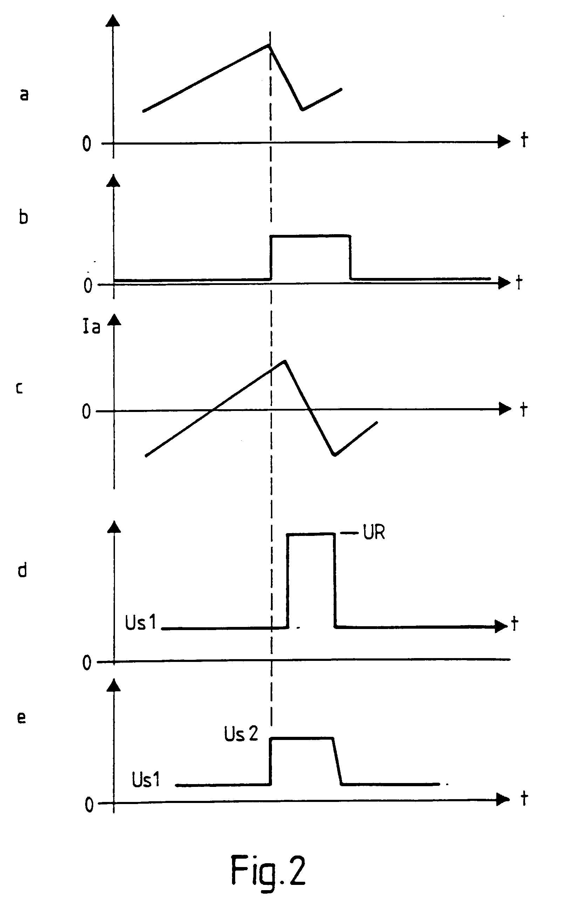

Dabei zeigen die kleinen Buchstaben a - f, an welchen Punkten in Fig. 1 die Spannungen und Ströme gemäß Fig. 2 stehen.

Die Vertikalablenkschaltung gemäß Fig. 1 enthält das IC vom Typ TDA 8178FS oder TDA 8179FS. An den Pin 1 ist die vertikalfrequente sägezahnförmige Spannung a mit einer Frequenz von 100 Hz angelegt. Der Pin 2 ist über die Entkopplungsdiode 1 mit der ersten Betriebsspannung +Us1 verbunden. An den Pin 3 ist eine Rücklaufbetriebsspannung UR angelegt, die größer ist als die erste Betriebsspannung Us1. Die im IC wirksame Betriebsspannung für die internen Stufen wird während des Hinlaufs vom Pin 2 und während des Rücklaufs vom Pin 3 abgenommen. Der Pin 5 ist an die Ablenkeinheit AE angeschlossen und liefert den sägezahnförmigen vertikalfrequenten Ablenkstrom Ia. Der Pin 6 führt während des Rücklaufs die erhöhte Betriebsspannung UR und ist über die Entkopplungsdiode 12 mit der ersten Betriebsspannung +Us1 verbunden. Die soweit beschriebene Schaltung ist bekannt und arbeitet einwandfrei bei einer Vertikalfrequenz von 50 Hz.

Für den Betrieb mit einer Vertikalfrequenz von 100 Hz ist die Schaltung durch die Zusatzschaltung mit den Bauteilen 2 - 11 erweitert. Diese Schaltung arbeitet folgendermaßen. Der angelegte Vertikal-Blanking-Impuls b, dessen Vorderflanke bei Beginn der abfallenden Flanke der Sägezahnspannung a beginnt, wird durch das Differenzierglied mit dem Kondensator 11 und dem Widerstand 10 differenziert. Von den differenzierten Impulsen wird durch die Diode 9 nur der positive Impuls ausgewertet, der somit auf den Punkt f gelangt. Dieser positive differenzierte Impuls steuert den Transistor 6 leitend, der wiederum über die Widerstände 4, 5 den Transistor 3 leitend steuert. Dadurch wird Pin 2 mit der höheren Betriebsspannung +Us2 verbunden. Die Diode 1 wird dadurch nichtleitend und trennt Pin 2 von der Betriebsspannung +Us1. Durch die interne Funktion des IC nimmt der Pin 6 den Wert der erhöhten Rücklaufbetriebsspannung UR an. Dadurch wird die Diode 12 nichtleitend und trennt Pin 6 von +Us1. Die erhöhte Spannung von d gelangt über den Spannungsteiler 7, 8 auf den Punkt f und hält dadurch, nach dem der differenzierte Impuls beendet ist, den Transistor 6 leitend. Dadurch bleibt auch der Transistor 3 leitend und die erhöhte Betriebsspannung Us2 am Pin 2 bestehen. Die Schaltung, die den Pin 2 auf die erhöhte Betriebsspannung +Us2 legt, wird also durch den differenzierten Impuls ausgelöst und danach durch den Impuls d vom Pin 6 gehalten. Der Kondensator 2 bewirkt, daß die Spannung e, die durch den leitenden Transistor 3 von Us1 auf Us2 erhöht ist, nach dem Abfall der Spannung d von UR auf Us1 wieder verzögert auf den Wert Us1 abfällt.

## Patentansprüche

1. Vertikalablenkschaltung mit einem IC nach der Art des TDA 8178FS oder TDA 8179FS, bei dem innerhalb des IC während des Rücklaufs eine Umschaltung von einer ersten Betriebsspannung (Us1) auf eine erhöhte Betriebsspannung (UR) erfolgt, mit einem Pin 2 für die Zuführung der ersten Betriebsspannung (+Us1) für den Hinlauf, einem Pin 3 für die Zuführung der Rücklaufbetriebsspannung (UR) und einem Pin 6, der während des Rücklaufs die erhöhte Rücklaufbetriebsspannung (UR) führt, **dadurch gekennzeichnet,** daß der Pin 2 während des Rücklaufs über einen Schalter (3) an eine zweite Betriebsspannung (Us2) angeschaltet ist, die größer ist als die erste Betriebsspannung (Us1), indem ein den Rücklauf markierender Impuls (b) über ein Differenzierglied (11, 10) an den Abgriff (f) eines an den Pin 6 angeschlossenen Spannungsteilers (7, 8) angelegt und der Abgriff(f) an die Basis eines Transistors (3) angeschlossen ist, dessen Kollektor/Emitter-Strecke zwischen dem Pin 2 und der zweiten Betriebsspannung (+Us2) liegt, wobei der Transistor (3) durch die Rücklaufbetriebsspannung (UR) leitend gehalten wird, nachdem der differenzierte Impuls beendet ist.

2. Schaltung nach Anspruch 1, **dadurch gekennzeichnet,** daß zwischen dem Differenzierglied (10, 11) und dem Abgriff (f) des Spannungsteilers (7, 8) eine Diode (9) liegt.

3. Schaltung nach Anspruch 1, **dadurch gekennzeichnet,** daß zwischen der mit Pin 2 verbundenen Elektrode des Transistors (3) und Erde ein Kondensator (2) liegt.

4. Schaltung nach Anspruch 1, **dadurch gekennzeichnet,** daß der Pin (2) des IC über eine Entkopplungsdiode (1) mit der ersten Betriebsspannung (+Us1) verbunden ist.

## Claims

1. Vertical deflection circuit including an IC of type TDA 8178FS or TDA 8179FS wherein switching between a first operating voltage (Us1) and an enhanced operating voltage (UR) occurs within the IC during the flyback period and which comprises a pin 2 for the supply of the first operating voltage (+Us1) for the forward sweep, a pin 3 for the supply of the flyback operating voltage (UR) and a pin 6 which carries the enhanced flyback operating voltage (UR) during the flyback period, **characterised in that**, the pin 2 is connected via a switch (3) during the flyback period to a second operating voltage (Us2) which is larger than the first operating voltage (Us1) in that a pulse (b) marking the flyback period is applied via a differentiating member (11, 10) to the tap (f) of a voltage divider (7, 8) connected to the pin 6 and the tap (f) is connected to the base of a transistor (3) whose collector/emitter path lies between the pin 2 and the second operating voltage (+Us2), whereby the transistor (3) is kept conductive by the flyback operating voltage (UR) after the differentiated pulse has come to an end.

2. Circuit in accordance with Claim 1, **characterised in that,** a diode (9) is located between the differentiating member (10, 11) and the tap (f) on the voltage divider (7, 8).

3. Circuit in accordance with Claim 1, characterised in that, a capacitor (2) is located between the electrode of the transistor (3) connected to pin 2 and earth.

4. Circuit in accordance with Claim 1, characterised in that, the pin (2) of the IC is connected to the first operating voltage (+Us1) via a decoupling diode (1).

## Revendications

1. Circuit de déflexion verticale comportant un circuit intégré du type TDA 8178FS ou TDA 8179FS, dans lequel, à l'intérieur du circuit intégré, se produit pendant la course de retour une commutation d'une première tension de fonctionnement (Us1) sur une tension de fonctionnement plus èlevée (UR), avec une broche 2 pour l'apport d'une première tension de fonctionnement (+Us1) pour la course aller, une broche 3 pour l'apport d'une tension de fonctionnement (UR) pour la course de retour et une broche 6 qui, pendant la course de retour amène la tension de fonctionnement majorée (UR) pour la course de retour, caractérisé en ce que, pendant la course de retour, la broche 2 est connectée par un interrupteur 3 à une seconde tension de fonctionnement (Us2), qui est plus èlevée que la première tension de fonctionnement (Us1), en ce qu'une impulsion b marquant la course de retour est appliquée par un organe de différentiation (11,10) à la prise (f) d'un diviseur de tension (7, 8) connecté à la broche 6 et la prise (f) est connectée à la base d'un transistor (3), dont le trajet émetteur/collecteur est situé entre la broche 2 et la seconde tension de fonctionnement (Us2), de sorte que le transistor (3) est maintenu conducteur par la tension de fonctionnement pour la course de retour après que l'impulsion différentielle est terminée.

2. Circuit selon la revendication 1, caractérisé en ce que entre l'organe de différentiation (10, 11) et la prise (f) du diviseur de tension (7, 8) se trouve une diode 9.

3. Circuit selon la revendication 1, caractérisé en ce que entre l'électrode du transistor (3) connectée à la broche 2 et la terre se trouve un condensateur (2).

4. Circuit selon la revendication 1, caractérisé en ce que la broche 2 du circuit intégré est connectée à la première tension de fonctionnement (Us1) par l'intermédiaire d'une diode de découplage (1).
